# EUROPÄISCHE PATENTSCHRIFT

(11) **EP 2 549 497 B1**
(45) Veröffentlichungstag und Bekanntmachung des Hinweises auf die Patenterteilung: **27.04.2016**
(21) Anmeldenummer: 12174624.2
(22) Anmeldetag: 02.07.2012
(51) Int. Cl.: H01F 38/14, G01R 27/18

(54) **Verfahren und Vorrichtung zur Einprägung einer Messsignalspannung in ein Stromversorgungsnetz**
Method and device for inducing a measurement signal voltage into a power supply network
Procédé et dispositif d'injection d'une tension de signal de mesure dans un réseau d'alimentation électrique

(30) Priorität: 20.07.2011 DE 102011079455
(43) Veröffentlichungstag der Anmeldung: 23.01.2013
(73) Patentinhaber: Bender GmbH & Co. KG, 35305 Grünberg (DE)
(72) Erfinder: Hackl, Dieter, 35463 Fernwald (DE); Macht, Burkhard, 35410 Hungen (DE)
(74) Vertreter: advotec.

(56) Entgegenhaltungen:
- EP-A1- 0 297 933
- EP-A1- 2 256 506
- WO-A1-2005/050229
- DE-A1- 3 422 252

## Beschreibung

Die Erfindung betrifft ein Verfahren zur Einprägung einer Messsignalspannung in ein Stromversorgungsnetz mit den Verfahrensschritten Bereitstellen eines Generatorsignals und induktive Übertragung des Generatorsignals in das Stromversorgungsnetz.

Weiterhin betrifft die Erfindung eine Vorrichtung zur Einprägung einer Messsignalspannung in ein Stromversorgungsnetz mit einem Signalgenerator zum Bereitstellen eines Generatorsignals und einer Übertragungseinrichtung zur induktiven Übertragung des Generatorsignals in das Stromversorgungsnetz.

Im Hinblick auf die Sicherstellung eines ausreichenden Personen- und Anlagenschutzes bei dem Betrieb elektrischer Stromversorgungssysteme kommt dem Isolationswiderstand eine besondere Bedeutung zu. Ein Absinken des Isolationswiderstands unter einen vorgegebenen Wert vermindert den Schutz gegen direktes und indirektes Berühren der elektrischen Anlage; darüber hinaus können Fehlerströme auftreten und zu Fehlfunktionen elektrischer Einrichtungen oder zu einer hohe Kosten verursachenden Betriebsunterbrechung führen. Auch aus brandschutztechnischen Gründen sind der Betreiber der Anlage und die Versicherungswirtschaft an einem ordnungsgemäßen technischen Zustand der Anlage in Bezug auf den Isolationswiderstand interessiert.

Im Bereich elektrischer Anlagen ist daher eine ständige Überwachung des Isolationswiderstandes erforderlich. Als aktives Messverfahren zur Isolationswiderstandsmessung hat sich die Einspeisung einer Wechselspannung als Messsignal wegen ihrer einfachen transformatorischen Ankopplung an das Leitungsnetz bei geerdeten Stromversorgungsnetzen bewährt.

Allerdings ist bei den Verfahren, die auf der Messung mit Wechselspannungen beruhen, zu beachten dass neben dem - als reine ohmsche Widerstandskomponente - betrachteten Isolationswiderstand auch die kapazitive Komponente der komplexwertigen Netzableitimpedanz eine maßgebliche Rolle spielt. Insbesondere bei räumlich ausgedehnten Leitungsnetzen kann die Netzableitkapazität derartige Größenordnungen annehmen, dass die Bestimmung des Isolationswiderstands durch kapazitive Ableitströme verfälscht werden würde. Diese kapazitiven Ableitströme sind bei vorgegebener Mess-(Wechsel-)Spannung abhängig von dem kapazitiven Leitwert, der wiederum mit steigender Frequenz zunimmt. Man wird daher bestrebt sein, die Messfrequenz möglichst niedrig zu halten, um zum einen bei ausgedehnten Leitungsanordnungen der großen Netzableitkapazität entgegenzuwirken und zum anderen den proportional zur Frequenz steigenden Betrag des kapazitiven Leitwerts zu minimieren.

Weiterhin führt eine niedrige Messfrequenz zu einer geringeren Strombelastung des Schutzleiters bei großen Netzableitkapazitäten. Damit fällt die Belastung des Schutzleiters durch funktionale Erfordernisse geringer aus und eine Gefährdung des Schutzkonzepts "Schutzleiter" kann weitgehend ausgeschlossen werden. Dies wiederum erhöht die Akzeptanz einer neuen Gerätetechnik.

Der Wahl einer geeigneten, möglichst niedrigen Messfrequenz kommt daher besondere Bedeutung zu. Eine niedrige Messfrequenz des eingeprägten Messsignals erlaubt die Überwachung größerer geerdeter Stromversorgungsnetze, zudem können auftretende höherfrequente Störungen, z. B. von Frequenzumrichtern, wegen des größeren Frequenzabstands mit weniger aufwendigen Filterschaltungen herausgefiltert werden.

So ist aus der Offenlegungsschrift DE 103 55 086 A1 aus dem Hause der Anmelderin bekannt, zur Bestimmung des Isolationswiderstands ein weitgehend rechteckförmiges Gleichtakt-Spannungssignal gegen Erde einzuspeisen, wobei die Einspeisung dieses Generatorsignals vorzugsweise über einen Transformator erfolgt. Die Messfrequenz ergibt sich aus der in dem zeitlichen Verlauf der Rechteckschwingung enthaltenen Grundfrequenz und wird durch eine Filterung von den übrigen auf dem Leitungsnetz vorhandenen höherfrequenten Signalanteilen getrennt. Vorgeschlagen wird bei einer Netzfrequenz von 50 Hz eine Messfrequenz von 175 Hz für das einzuspeisende Generatorsignal.

Als nachteilig erweist sich bei diesem Verfahren mit transformatorischer Einspeisung des Generatorsignals, dass der gewünschten Ausweitung des Messfrequenzbereichs nach tiefen Frequenzen hin durch die Verwendung des Transformators Grenzen gesetzt sind. Da die sekundärseitig induzierte Spannung proportional zur zeitlichen Änderung der magnetischen Induktion ist, sinkt auch die induzierte Spannung bei abnehmender Grundfrequenz des eingespeisten Signals. Um diese Abnahme der Spannung auszugleichen, könnte in gleichem Maße die Windungszahl und/oder der Kernquerschnitt des Transformators erhöht werden. Dies aber würde den Einsatz unverhältnismäßig teurer und großer sowie hinsichtlich des Leistungsbedarfs unwirtschaftlicher Transformatoren bedeuten. Um bei Messsignalfrequenzen von deutlich unter 100 Hz noch eine für die zuverlässige Anwendung des Verfahrens ausreichende Spannungsamplitude auf der Sekundärseite zu erzielen, sind derart teure Transformatoren erforderlich, dass entsprechende Endgerätepreise für marktgerechte Produkte in dem beabsichtigten Anwenderumfeld nicht durchsetzbar wären. Nach dem Stand der Technik ist aus wirtschaftlichen Erwägungen heraus die Messfrequenz bei transformatorischer Einspeisung auf Werte oberhalb von ca. 100 Hz begrenzt. Zusammenfassend lässt sich daher festhalten, dass die (primärseitige) Erzeugung eines niederfrequenten Generatorsignals kein Problem darstellt, wohl aber dessen produktgerechte induktive Übertragung bzw. Einkopplung in das Stromversorgungsnetz.

Der vorliegenden Erfindung liegt somit die Aufgabe zu Grunde, ein Verfahren und eine Vorrichtung zur Einprägung von Messsignalspannungen in ein Stromversorgungsnetz derart weiter zu entwickeln, dass eine kostengünstige Einprägung niederfrequenter Messsignale ausführbar ist.

Diese Aufgabe wird bezogen auf ein Verfahren in Verbindung mit dem Oberbegriff des Anspruchs 1 dadurch gelöst, dass das Generatorsignal alternierend mit zwei Abtast-Haltegliedern abgetastet wird, die Abtastwerte alternierend einer ersten Impulsfolge und einer zweiten Impulsfolge zugeordnet werden, die Impulsfolgen getrennt induktiv übertragen werden, um induzierte Teilspannungen zu erzeugen, und die sekundärseitige Messsignalspannung aus der Addition der induzierten Teilspannungen gebildet wird.

Der Grundgedanke der vorliegenden Erfindung beruht in vorteilhafterweise auf dem Einsatz von zwei Transformatoren kleinerer Baugröße statt nur eines wesentlich teureren und größeren Transformators. Die beiden Transformatoren werden mit sehr viel höherer Frequenz betrieben, vorzugsweise im Bereich von 100 Hz bis in den MHz-Bereich hinein, und können dadurch gemäß den aus dem Induktionsgesetz folgenden Erkenntnissen bei gleichbleibender induzierter Spannung in ihrem Kernquerschnitt, also in ihren Abmessungen reduziert werden - einhergehend mit der beabsichtigten Kostenreduktion. Um sekundärseitig die erwünschte niederfrequente Messsignalspannung zu erzielen, wird ein niederfrequentes Generatorsignal zunächst alternierend mit zwei Abtast-Haltegliedern abgetastet, wobei die Abtastrate ein Vielfaches über der Grundfrequenz des Generatorsignals liegt. Dazu werden in äquidistanten Zeitabständen die jeweils aktuellen Spannungswerte des Generatorsignals abwechselnd von zwei Abtast-Haltegliedern abgegriffen und abwechselnd einer ersten Impulsfolge und einer zweiten Impulsfolge zugeordnet. Durch die alternierende Zuordnung entstehen zwei Impulsfolgen, die zueinander um die Dauer der Haltezeit zeitverschoben sind, wobei alternierend die eine Impulsfolge den Wert Null annimmt, während die jeweils andere einen Abtastwert liefert. Die Impulsfolgen bestehen infolge der Abtast-Halteschaltung aus Rechteck-Impulsen, deren Höhe dem jeweiligen Wert des abgetasteten Generatorsignals entspricht. Die Impulsfolgen werden getrennt über zwei verschiedene Transformatoren induktiv übertragen. Da die Abtastung mit einer wesentlich über der Grundfrequenz des Generatorsignals liegenden Abtastrate erfolgt und die aus den Abtastwerten generierten Impulsfolgen somit einer viel größeren Änderungsgeschwindigkeit unterliegen als das zeitkontinuierliche Generatorsignal, werden die Transformatoren mit einer sehr viel höheren Frequenz angesteuert. Erfindungsgemäß wird auf diese Weise eine im Vergleich zu der direkten Ansteuerung mit dem zeitkontinuierlichen Generatorsignal eine höhere induzierte Spannung erzielt. Sekundärseitig wird die Messsignalspannung aus der Addition der zueinander zeitverschobenen induzierten (Teil-)Spannungsimpulsen gebildet, um über den gesamten Zeitverlauf die induzierten Spannungsanteile beider Übertragungswege nutzen zu können. In vorteilhafterweise wird somit ein niederfrequentes Generatorsignal durch Abtastung auf die Sekundärseite übertragen und steht dort aufgabengemäß als niederfrequentes Messsignal zur Verfügung.

In weiterer vorteilhafter Ausgestaltung erfolgt die Abtastung durch die Abtast-Halteglieder jeweils mit einer Pulsfrequenz fₚᵤₗₛₑ = 1/tₚᵤₗₛₑ, wobei die Haltezeit t_{hold} jeweils einer halben Pulsdauer entspricht. Durch diese Wahl der Abtastparameter wird erreicht, dass die Abtastwerte der einen Impulsfolge jeweils den Wert Null besitzen während die Abtastwerte der jeweils anderen Impulsfolge den abgetasteten Wert des Generatorsignals annehmen. Eine erfindungsgemäße Addition der beiden Signalanteile liefert damit einen Spannungsverlauf, der die niederfrequente Signalgeneratorspannung treppenförmig annähert und nach entsprechender Tiefpassfilterung sekundärseitig die gewünschte Messspannung niedriger Frequenz generiert.

Mit Vorteil erfolgt die getrennte induktive Übertragung der Impulsfolgen periodisch fortgesetzt in zwei Zeitabschnitten, wobei in einem ersten Zeitabschnitt, der mit der Haltezeit des ersten Abtast-Halteglieds übereinstimmt, der Magnetkern eines ersten Transformators durch einen primärseitig anliegenden Rechteck-Impuls der ersten Impulsfolge ausgesteuert wird, ein zweiter Transformator entsprechend der zeitverschobenen zweiten Impulsfolge kein Generatorsignal empfängt und primärseitig und sekundärseitig während des Abbaus der gespeicherten Energie auf 0V gehalten wird, wobei sich infolge der primärseitigen Aussteuerung auf der Sekundärseite des ersten Transformators eine erste Teilspannung einstellt. In dem sich unmittelbar an den ersten Zeitabschnitt anschließenden zweiten Zeitabschnitt, der mit der Haltezeit des zweiten Abtast-Halteglieds übereinstimmt, wird der Magnetkern eines zweiten Transformators durch einen primärseitig anliegenden Rechteck-Impuls der zweiten Impulsfolge ausgesteuert, der erste Transformator empfängt entsprechend der zeitverschobenen ersten Impulsfolge kein Generatorsignal und wird primärseitig und sekundärseitig während des Abbaus der gespeicherten Energie auf 0V gehalten, wobei sich infolge der primärseitigen Aussteuerung auf der Sekundärseite des zweiten Transformators eine zweite Teilspannung einstellt.

In dem ersten Zeitabschnitt wird der erste Transformator mit einem Rechteck-Impuls angesteuert, während der zweite Transformator zweckmäßigerweise durch geeignete Schaltungstechnik von dem Generator abgekoppelt wird und bei dem primär- und sekundärseitiges Kurzschließen ein Abbau der gespeicherten Energie ermöglicht wird. Die in dem Stromversorgungsnetz erzeugte Messspannung wird in diesem ersten Zeitabschnitt von der in der Sekundärwicklung des ersten Transformators induzierten Spannung gebildet. In dem sich unmittelbar an den ersten Zeitabschnitt anschließenden zweiten Zeitabschnitt wird der zweite Transformator mit einem Rechteck-Impuls angesteuert, während in dem ersten Transformator bei dem Kurzschließen der Wicklungen ein Energieabbau stattfindet. In diesem zweiten Zeitabschnitt wird die erzeugte Messspannung von der in der Sekundärwicklung induzierten Spannung des zweiten Transformators gebildet. Unmittelbar an diesen zweiten Zeitabschnitt schließen sich in periodischer Fortsetzung weitere Zyklen aus erstem und zweitem Zeitabschnitt an.

Das Generatorsignal kann einen beliebigen Signalverlauf einschließlich einer Gleichspannung annehmen und insbesondere eine rechteckförmige Signalspannung sein. Ein rechteckförmiger Spannungsverlauf ist einfach zu generieren und spiegelt in seiner Grundfrequenz die Signalfrequenz eines Sinussignals wider. Durch Filterschaltungen kann diese Grundfrequenz separiert und ausgewertet werden.

Bezogen auf eine Vorrichtung wird die Aufgabe durch die Vorrichtung gemäß dem Anspruch 5 gelöst. Die Übertragungseinrichtung weist zur induktiven Übertragung des Generatorsignals in das Stromversorgungsnetz eine primärseitige Schalteinrichtung zur Abtastung des Generatorsignals und zur Aufteilung der Abtastwerte in zwei zueinander zeitverschobene Impulsfolgen, zwei ausgangsseitig in Reihe geschaltete Transformatoren zur getrennten induktiven Übertragung der Impulsfolgen und eine sekundärseitige Schalteinrichtung zur Addition der zeitverschobenen induzierten Impulsfolgen auf.

Die primärseitige Schalteinrichtung dient zum einen als Abtasteinrichtung für das Generatorsignal, zum anderen bewirkt sie die Aufteilung der Abtastwerte in zwei zueinander zeitverschobene Impulsfolgen. Die zwei Impulsfolgen speisen dann vorteilhafterweise zwei getrennte Transformotoren.

Um die Aufgaben der Zeitdiskretisierung und der Impulsfolgengenerierung sowie den Abbau der im Magnetkern des jeweiligen Transformators gespeicherten Energie zu ermöglichen, besteht die primärseitige Schalteinrichtung aus zwei Schaltelementen, die die Primärwicklung des jeweiligen Transformators wechselseitig mit dem Signalgenerator verbinden und aus zwei weiteren Schaltelementen, die die jeweilige Primärwicklung wechselseitig kurzschließen. Mit dieser primärseitigen Schaltungsanordnung wird in den Zeitabschnitten, in denen einer der beiden Transformatoren mit dem Generatorsignal verbunden ist, der jeweils andere Transformator kurzgeschlossen und dessen gespeicherte Energie abgebaut.

Mit Vorteil besteht die sekundärseitige Schalteinrichtung aus einer ersten Schaltgruppe, die die induzierten Spannungen des ersten Transformators auf das Stromversorgungsnetz aufschaltet bzw. dessen Sekundärwicklungen kurzschließt und einer in Reihe geschalteten zweiten Schaltgruppe, die wechselseitig dazu die induzierten Spannungen des zweiten Transformators auf das Stromversorgungsnetz aufschaltet bzw. dessen Sekundärwicklungen kurzschließt.

Diese Ausführung der sekundärseitigen Schalteinrichtung bewirkt bei geöffneter erster Schaltgruppe die Aufschaltung der sekundärseitig induzierten Spannung des ersten Transformators auf das Leitungsnetz - wobei in der ersten und in der zweiten Schaltgruppe für jeden Leiter ein Schaltelement vorgesehen ist- und lässt gleichzeitig bei geschlossener zweiter Schaltgruppe den Energieabbau in dem zweiten Transformator zu. Anschließend wird die erste Schaltgruppe geschlossen und die zweite Schaltgruppe geöffnet, wodurch in dem ersten Transformator ein Energieabbau stattfindet und die in dem zweiten Transformator induzierte Spannung auf das Leitungsnetz übertragen wird.

In bevorzugter Ausführung sind die Schaltelemente der Schalteinrichtungen als Halbleiterschaltelemente ausgeführt. Als (Leistungs-) Halbleiterbauelemente können Dioden, Transistoren oder Thyristoren eingesetzt werden; diese arbeiten verschleißfrei und sind in der Lage hohe Schaltfrequenzen zu verarbeiten.

Weiterhin besitzt die Vorrichtung eine Steuerschaltung zur zeitlichen Ansteuerung der primären und sekundären Schalteinrichtungen. Mit Hilfe der Steuereinrichtung werden die Öffnungs- und Schließzeitpunkte der Schaltelemente der primärseitigen und der sekundärseitigen Schalteinrichtung bestimmt, so dass die Abtastung, der Energieabbau und die Aufschaltung auf das Stromversorgungsnetz für beide Übertragungswege synchronisiert zueinander erfolgen können.

In einer zweckmäßigen Ausgestaltung weist jeder der beiden Transformatoren einen kleineren Kernquerschnitt auf als ein die gleiche Sekundärspannung erzeugender einzelner Transformator bei konventioneller niederfrequenter transformatorischer Übertragung. Die erfindungsgemäße Vorrichtung ermöglicht in dieser Ausgestaltung den Einsatz von Transformatoren kleinerer Baugröße, die den Kostenanteil der Transformatoren reduzieren und zu marktgerechten Produkten führen.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern. Es zeigen:
- **Fig. 1:**: einen Anwendungsfall der vorliegenden Erfindung,
- **Fig. 2:**: einen prinzipiellen Aufbau der erfindungsgemäßen Vorrichtung,
- **Fig. 3:**: Spannungsverläufe eines abgetasteten sinusförmigen Generatorsignals und
- **Fig. 4:**: Spannungsverläufe eines abgetasteten rechteckförmigen Generatorsignals.

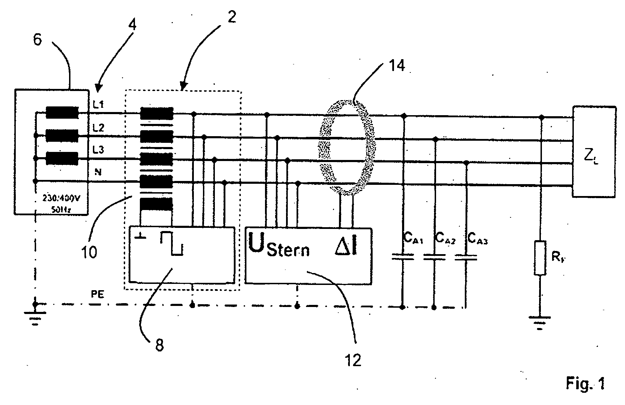

**Fig. 1** zeigt einen Anwendungsfall des erfindungsgemäßen Verfahrens sowie der erfindungsgemäßen Vorrichtung 2 zur Einprägung einer Messsignalspannung U in ein Stromversorgungsnetz 4. Das Stromversorgungsnetz 4 ist als geerdetes Netz 4 mit drei aktiven Leitern L1, L2, L3 und einem Neutralleiter N ausgeführt. Zwischen der Netzeinspeisung 6 und dem als Lastwiderstand dargestellten Verbraucher Z_{L} findet die Einprägung eines Messsignals mittels der erfindungsgemäßen Vorrichtung 2 statt - in **Fig. 1** schematisch dargestellt durch einen Signalgenerator 8 und einen Gleichtaktübertrager 10. Die Filterung und Auswertung des Messsignals zur Bestimmung eines (ohmschen) Isolationswiderstands R_{F} übernimmt eine Auswerteeinrichtung 12, an die ein Messstromwandler 14 angeschlossen ist, der einen in den Leitern L1, L2, L3 und N auftretenden Differenzstrom ΔI erfasst. Eine kapazitive Komponente der komplexwertigen Netzableitimpedanz ist vereinfacht für jeden aktiven Leiter durch die jeweilige Kapazität C_{A1}, C_{A2} und C_{A3} dargestellt.

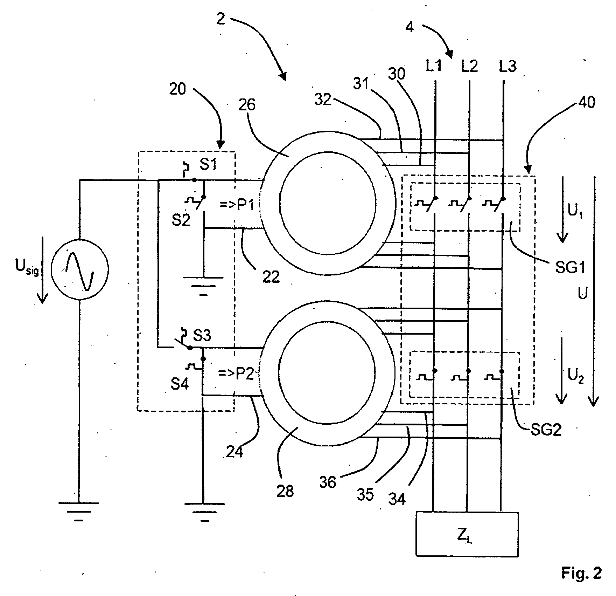

In **Fig. 2** ist der prinzipielle Aufbau der erfindungsgemäßen Vorrichtung 2 dargestellt, an Hand dessen auch der Ablauf des erfindungsgemäßen Verfahrens schrittweise verdeutlicht wird. In der schematischen Darstellung ist eine niederfrequente Generatorsignalspannung U_{sig} über eine primärseitige Schalteinrichtung 20 mit Primärwicklungen 22, 24 zweier Transformatoren 26, 28 verbunden. Sekundärseitig weisen die beiden Transformatoren 26, 28 jeweils drei Wicklungen 30, 31, 32 bzw. 34, 35, 36 auf, die jeweils mit den Leitern L1, L2 und L3 verbunden sind, wobei eine sekundärseitige Schalteinrichtung 40 die Aufschaltung einer ersten und einer zweiten induzierten Teilspannung U₁, U₂ bewirkt. Die Einprägung der aus den induzierten Teilspannungen U₁, U₂ zusammengesetzten Messsignalspannung U vollzieht sich für alle aktiven Leiter L1, L2, L3 und den Neutralleiter N in gleicher Weise; aus Gründen einer vereinfachten zeichnerischen Darstellung ist daher der Neutralleiter N in **Fig. 2** nicht eingezeichnet.

Im Einzelnen besteht die primärseitige Schalteinrichtung 20 aus vier Schaltelementen S1, S2, S3 und S4, wobei die Schaltelemente S1 und S3 wechselseitig die Verbindung zwischen dem Generatorsignal U_{sig} und den Primärwicklungen 22, 24 des jeweiligen Transformators 26, 28 herstellen bzw. auftrennen und die Schaltelemente S2 und S4 die jeweiligen Primärwicklungen 22, 24 wechselseitig kurzschließen. Die Schaltelemente S1 und S3 können dabei als Realisierungen des Abtasters einer Abtastschaltung aufgefasst werden. Zu dem in **Fig. 2** dargestellten Zeitpunkt in einem Zeitabschnitt T1 ist das Schaltelement S1 geschlossen, während die Schaltelemente S2 und S3 geöffnet sind. Damit liegt die Generatorsignalspannung U_{sig} an der Primärwicklung 22 des ersten Transformators 26 an, während die Verbindung der Primärwicklung 24 des zweiten Transformators 28 zu dem Generatorsignal U_{sig} aufgetrennt ist. Gleichzeitig ist das Schaltelement S4 geschlossen, wodurch die Primärwicklung 24 des zweiten Transformators 28 kurzgeschlossen und ein Abbau der in dem vorangegangenen Abtastzyklus gespeicherten Energie ermöglicht wird. In einem sich unmittelbar an den Zeitabschnitt, T1 anschließenden Zeitabschnitt T2 wechseln die Schaltelemente S1, S2, S3 und S4 ihren jeweiligen Zustand, so dass über das nun geschlossene Schaltelement S3 und das geöffnete Schaltelement S4 die Primärwicklung 24 des zweiten Transformators 28 mit der Generatorsignalspannung U_{sig} verbunden ist und bei geöffnetem Schaltelement S1 über das geschlossene Schaltelement S2 ein Energieabbau im ersten Transformator 26 stattfinden kann.

Die sekundärseitige Schalteinrichtung 40 umfasst eine erste Schaltgruppe SG1 und eine zweite Schaltgruppe SG2, wobei sich die Schaltelemente der ersten Schaltgruppe SG1 auf den Leiterstrecken der Leiter L1, L2 und L3 zwischen den Verbindungspunkten der Sekundärwicklungen 30, 31, 32 des ersten Transformators 26 und die Schaltelemente der zweiten Schaltgruppe SG2 sich zwischen den Verbindungspunkten der Sekundärwicklungen 34, 35, 36 des zweiten Transformators 28 befinden. Die Schaltgruppen SG1 und SG2 sind in der Weise synchron zu den Schaltelementen S1 bis S4 angesteuert, dass in dem ersten Zeitabschnitt T1, in dem die Generatorsignalspannung U_{sig} auf den ersten Transformator 26 geschaltet ist, auch eine in dem ersten Transformator 26 induzierte erste Teilspannung U₁ über die geöffneten Schaltelemente der ersten Schaltgruppe SG1 auf die Leiter L1, L2 und L3 übertragen wird. Gleichzeitig sind die Schaltelemente der zweiten Schaltgruppe SG2 geschlossen und ermöglichen so einen sekundärseitigen Energieabbau in dem zweiten Transformator 28 über dessen kurzgeschlossenen Wicklungen 34, 35, 36. Entsprechend ermöglichen die geöffneten Schaltelemente der Schaltgruppe SG2 in dem Zeitabschnitt T2 die Übertragung der in dem zweiten Transformator 28 induzierten zweiten Teilspannung U₂ in das Leitungsnetz 4, während in den Wicklungen 30, 31, 32 des ersten Transformators 26 ein über die geschlossenen Schaltelemente der ersten Schaltgruppe SG1 ein Ausgleichsstrom zum Energieabbau fließen kann.

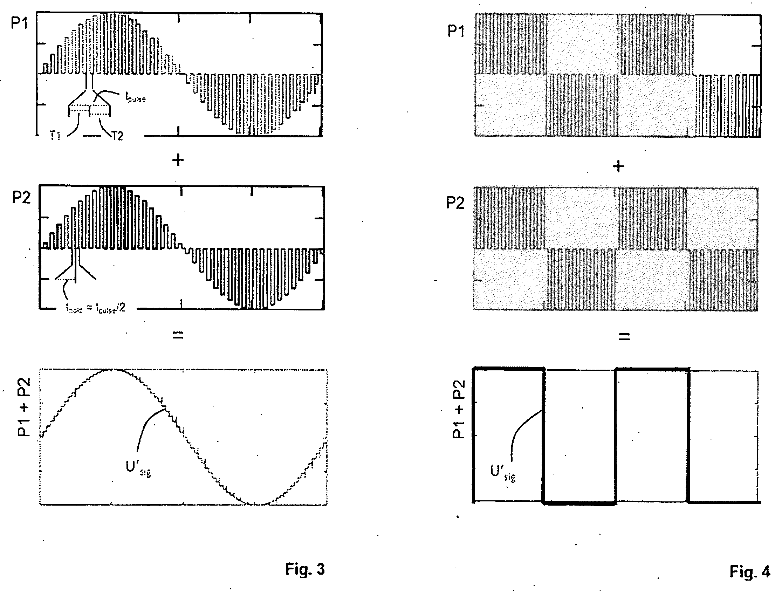

Durch die primärseitig erfolgende alternierende Abtastung mit der primärseitigen Schalteinrichtung 20 in Verbindung mit der synchron dazu gesteuerten sekundärseitigen Schalteinrichtung 40 werden zwei um eine Haltezeit t_{hold} zueinander zeitverschobene Impulsfolgen P1 und P2 gebildet (siehe **Fig. 3** und **Fig. 4****).** Diese Impulsfolgen P1 und P2 werden dann getrennt über den ersten und zweiten Transformator 26, 28 übertragen. Somit wird die niederfrequente primärseitige Generatorsignalspannüng U_{sig} sekundärseitig zeitdiskret abgebildet und kann mittels geeigneter Tiefpassfilterung unter Beachtung des Abtasttheorems fehlerfrei rekonstruiert werden. Damit steht in dem Stromversorgungsnetz 4 die gewünschte niederfrequente Messsignalspannung U zur Verfügung.

Die **Fig.3** und die **Fig. 4** zeigen die Spannungsverläufe eines abgetasteten Generatorsignals U'_{sig} und verdeutlichen dessen primärseitige Zusammensetzung aus der Addition der zwei zueinander zeitversetzten Impulsfolgen P1 und P2. Die Abtastung pro Impulsfolge erfolgt mit der Pulsfrequenz fₚᵤₗₛₑ und die Haltezeit t_{hold} entspricht einer halben Pulsdauer tₚᵤₗₛₑ=1/fₚᵤₗₛₑ. Durch den Zeitversatz um eine Haltezeit t_{hold} füllen die Impulsfolgen P1, P2 wechselseitig die Abtastlücken und summieren sich so zu einem abgetasteten Generatorsignals U'_{sig}, welches eine sinusförmige **(****Fig. 3****)** Generatorsignalspannung U_{sig} treppenförmig approximiert. Im Falle einer rechteckförmigen **(****Fig. 4****)** Generatorsignalspannung U_{sig} führt die Überlagerung der Impulsfolgen P1, P2 zu einer nahezu exakten Nachbildung der Generatorsignalspannung U_{sig}.

## Patentansprüche

1. Verfahren zur Einprägung einer Messsignalspannung in ein Stromversorgungsnetz mit den Verfahrensschritten
- Bereitstellen eines Generatorsignals,
- induktive Übertragung des Generatorsignals in das Stromversorgungsnetz,
**dadurch gekennzeichnet,**
**dass**
- das Generatorsignal (U_{sig}) alternierend mit zwei Abtast-Haltegliedern (20, S1, S3) abgetastet wird,
- die Abtastwerte alternierend einer ersten Impulsfolge (P1) und einer zweiten Impulsfolge (P2) zugeordnet werden,
- die Impulsfolgen (P1, P2) getrennt induktiv übertragen werden, um induzierte Teilspannungen (U1, U2) zu erzeugen,
- die sekundärseitige Messsignalspannung (U) aus der Addition der induzierten Teilspannungen (U1, U2) gebildet wird.

2. Verfahren nach Anspruch 1,
**dadurch gekennzeichnet,**
**dass** die Abtastung durch die Abtast-Halteglieder (20, S1, S3) jeweils mit einer Pulsfrequenz fₚᵤₗₛₑ erfolgt und die Haltezeit jeweils einer halben Pulsdauer entspricht.

3. Verfahren nach Anspruch 1 oder 2,
**dadurch gekennzeichnet,**
**dass** die getrennte induktive Übertragung der Impulsfolgen (P1, P2) periodisch fortgesetzt in zwei Zeitabschnitten (T1, T2) erfolgt, wobei in einem ersten Zeitabschnitt (T1), der mit der Haltezeit (t_{hold}) des ersten Abtast-Halteglieds (20, S1) übereinstimmt,
- der Magnetkern eines ersten Transformators (26) durch einen primärseitig anliegenden Rechteck-Impuls der ersten Impulsfolge (P1) ausgesteuert wird,
- ein zweiter Transformator (28) entsprechend der zeitverschobenen zweiten Impulsfolge (P2) kein Generatorsignal (U_{sig}) empfängt und primärseitig und sekundärseitig während des Abbaus der gespeicherten Energie auf 0V gehalten wird,
- sich infolge der primärseitigen Aussteuerung auf der Sekundärseite des ersten Transformators (26) die erste Teilspannung (U1) einstellt
und in dem sich unmittelbar an den ersten Zeitabschnitt (T1) anschließenden zweiten Zeitabschnitt (T2), der mit der Haltezeit (t_{hold}) des zweiten Abtast-Halteglieds (20, S3) übereinstimmt,
- der Magnetkern eines zweiten Transformators (28) durch einen primärseitig anliegenden Rechteck-Impuls der zweiten Impulsfolge (P2) ausgesteuert wird,
- der erste Transformator (26) entsprechend der zeitverschobenen ersten Impulsfolge (P1) kein Generatorsignal (U_{sig}) empfängt und primärseitig und sekundärseitig während des Abbaus der gespeicherten Energie auf 0V gehalten wird,
- sich infolge der primärseitigen Aussteuerung auf der Sekundärseite des zweiten Transformators (28) die zweite Teilspannung (U2) einstellt.

4. Verfahren nach einem der Ansprüche 1 bis 3,
**dadurch gekennzeichnet,**
**dass** das Generatorsignal (U_{sig}) einen beliebigen Signalverlauf einschließlich einer Gleichspannung annimmt und insbesondere eine rechteckförmige Signalspannung ist.

5. Vorrichtung zur Einprägung einer Messsignalspannung in ein Stromversorgungsnetz, die einen Signalgenerator zum Bereitstellen eines Generatorsignals und eine Übertragungseinrichtung zur induktiven Übertragung des Generatorsignals in das Stromversorgungsnetz aufweist,
**dadurch gekennzeichnet,**
**dass** die Übertragungseinrichtung eine primärseitige Schalteinrichtung (20) zur Abtastung des Generatorsignals (U_{sig}) und zur Aufteilung der Abtastwerte in zwei zueinander zeitverschobene Impulsfolgen (P1, P2), zwei ausgangsseitig in Reihe geschaltete Transformatoren (26, 28) zur getrennten induktiven Übertragung der Impulsfolgen (P1, P2) und eine sekundärseitige Schalteinrichtung (40) zur Addition der zeitverschobenen induzierten Impulsfolgen aufweist.

6. Vorrichtung nach Anspruch 5,
**dadurch gekennzeichnet,**
**dass** die primärseitige Schalteinrichtung (20) aus zwei Schaltelementen besteht (S1, S3), die die Primärwicklung (22, 24) des jeweiligen Transformators (26, 28) wechselseitig mit dem Signalgenerator (U_{sig}) verbinden und zwei weitere Schaltelemente aufweist (S2, S4), die die jeweilige Primärwicklung (22, 24) wechselseitig kurzschließen.

7. Vorrichtung nach Anspruch 5 oder 6,
**dadurch gekennzeichnet,**
**dass** die sekundärseitige Schalteinrichtung (40) aus einer ersten Schaltgruppe (SG1) besteht, die die induzierten Spannungen (U₁) des ersten Transformators (26) auf das Stromversorgungsnetz (4) aufschaltet oder dessen Sekundärwicklungen (30, 31, 32) kurzschließt und einer in Reihe geschalteten zweiten Schaltgruppe (SG2), die wechselseitig dazu die induzierten Spannungen (U₂) des zweiten Transformators auf das Stromversorgungsnetz (4) aufschaltet oder dessen Sekundärwicklungen (34, 35, 36) kurzschließt.

8. Vorrichtung nach einem der Ansprüche 6 oder 7,
**dadurch gekennzeichnet,**
**dass** die Schaltelemente (S1, S2, S3, S4, SG1, SG2) der Schalteinrichtungen (20, 40) als Halbleiterschaltelemente ausgeführt sind.

9. Vorrichtung nach einem der Ansprüche 5 bis 8,
**gekennzeichnet durch**
eine Steuerschaltung zur zeitlichen Ansteuerung der primären und sekundären Schalteinrichtungen (20, 40).

10. Vorrichtung nach einem der Ansprüche 5 bis 9,
**dadurch gekennzeichnet,**
**dass** jeder der beiden Transformatoren (26, 28) einen kleineren Kernquerschnitt aufweist als ein die gleiche Sekundärspannung erzeugender einzelner Transformator bei konventioneller niederfrequenter transformatorischer Übertragung.

## Claims

1. A method for impressing a measuring-signal voltage on a power supply network comprising the steps of
- providing a generator signal,
- inductive transmission of the generator signal into the power supply network,
**characterised in that**
- the generator signal (U_{sig}) is sampled alternately by two sample-and-hold elements (20, S1, S3),
- the sampled values are alternately allocated to a first pulse sequence (P1) and a second pulse sequence (P2),
- the pulse sequences (P1, P2) are separately inductively transmitted so as to generate induced partial voltages (U1, U2),
- the secondary-side measuring-signal voltage (U) is formed by adding the induced partial voltages (U1, U2) together.

2. The method according to claim 1,
**characterised in that**
sampling by the sample-and-hold elements (20, S1, S3) is performed using a pulse frequency fₚᵤₗₛₑ in each case and **in that** each hold time corresponds to half a pulse duration.

3. The method according to claim 1 or 2,
**characterised in that**
the separate inductive transmission of the pulse sequences (P1, P2) continues periodically over two time periods (T1, T2), wherein in a first time period (T1) coinciding with the hold time (t_{hold}) of the first sample-and-hold element (20, S1),
- the magnetic core of a first transformer (26) is modulated by a rectangular pulse of the first pulse sequence (P1) present on the primary-side,
- a second transformer (28), corresponding to the time-shifted second pulse sequence (P2), does not receive a generator signal (U_{sig}) and is held at 0V on the primary side and the secondary side during degradation of the stored energy,
- due to the primary-side modulation, the first partial voltage (U1) is formed on the secondary side of the first transformer (26),
and wherein in the second time period (T2) coinciding with the hold time (t_{hold}) of the second sample-and-hold element (20, S3) and immediately following the first time period (T1),
- the magnetic core of the second transformer (28) is modulated by a rectangular pulse of the second pulse sequence (P2) present on the primary side,
- the first transformer (26), corresponding to the time-shifted first pulse sequence (P1), does not receive a generator signal (U_{sig}) and is held at 0V on the primary side and the secondary side during degradation of the stored energy,
- due to the primary-side modulation, the second partial voltage (U2) is formed on the secondary side of the second transformer (28).

4. The method according to any one of claims 1 to 3,
**characterised in that**
the generator signal (U_{sig}) assumes any given signal waveform including a DC voltage and is, in particular, a rectangular-shaped signal voltage.

5. A device for impressing a measuring-signal voltage on a power supply network, the device comprising a signal generator for providing a generator signal and a transmitting unit for inductively transmitting the generator signal into the power supply network,
**characterised in that**
the transmitting unit comprises a primary-side switching unit (20) for sampling the generator signal (U_{sig}) and for dividing the sampled values into two pulse sequences (P1, P2) time-shifted against each other, two transformers (26, 28) series-connected on the output side for separate inductive transmission of the pulse sequences (P1, P2), and a secondary-side switching unit (40) for adding the time-shifted induced pulse sequences together.

6. The device according to claim 5,
**characterised in that**
the primary-side switching unit (20) consists of two switching elements (S1, S3) that alternately connect the primary winding (22, 24) of the respective transformer (26, 28) with the signal generator (U_{sig}), and has two further switching elements (S2, S4), which alternately short-circuit the respective primary winding (22, 24).

7. The device according to claim 5 or 6,
**characterised in that**
the secondary-side switching unit (40) consists of a first switching group (SG1), which connects the induced voltages (U1) of the first transformer (26) to the power supply network (4) or short-circuits its secondary windings (30, 31, 32), and a series-connected second switching group (SG2), which alternately thereto connects the induced voltages (U2) of the second transformer to the power supply network (4) or short-circuits its secondary windings (34, 35, 36).

8. The device according to claim 6 or 7,
**characterised in that**
the switching elements (S1, S2, S3, S4, SG1, SG2) of switching units (20, 40) are implemented as semi-conductor switching elements.

9. The device according to any one of claims 5 to 8,
**characterised by**
a control circuit for time control of the primary and secondary switching units (20, 40).

10. The device according to any one of claims 5 to 9,
**characterised in that**
each of the two transformers (26, 28) has a smaller core cross-section than a single transformer generating the same secondary voltage for a conventional low-frequency transmission with the aid of a transformer.

## Revendications

1. Procédé de l'application d'une tension de signal de mesure à un réseau d'alimentation électrique comprenant les étapes de
- fournir un signal de générateur,
- transmettre par induction le signal de générateur dans le réseau d'alimentation électrique,
**caractérisé en ce que**
- le signal de générateur (U_{sig}) est échantillonné en alternance par deux éléments d'échantillonnage et maintien (20, S1, S3),
- les valeurs d'échantillonnage sont attribuées en alternance à une première séquence d'impulsions (P1) et à une deuxième séquence d'impulsions (P2),
- les séquences d'impulsions (P1, P2) sont transmises séparément par induction afin de générer des tensions partielles (U1, U2) induites,
- la tension de signal de mesure (U) côté primaire est formée en additionnant les tensions partiales (U1, U2) induites.

2. Procédé selon la revendication 1,
**caractérisé en ce que**
l'échantillonnage par les éléments d'échantillonnage et maintien (20, S1, S3) est effectué à une fréquence d'impulsion fₚᵤₗₛₑ et chaque temps de maintien correspond à la moitié d'une durée d'impulsion.

3. Procédé selon la revendication 1 ou la revendication 2,
**caractérisé en ce que**
la transmission séparée par induction des séquences d'impulsions (P1, P2) se prolonge périodiquement dans deux périodes (T1, T2), dans lesquelles dans une première période (T1) coïncidant avec le temps de maintien (t_{hold}) du premier élément d'échantillonnage et maintien (20, S1),
- le noyau magnétique d'un premier transformateur (26) est modulé par une impulsion rectangulaire de la première séquence d'impulsions (P1) appliquée du côté primaire,
- un deuxième transformateur (28) ne reçoit pas de signal de générateur (U_{sig}) selon la deuxième séquence d'impulsions (P2) décalée dans le temps et est maintenu à 0 V du côté primaire et du côté secondaire durant la réduction de l'énergie accumulée,
- par suite de la modulation côté primaire, la première tension partielle (U1) s'établit du côté secondaire du premier transformateur (26),
et dans la deuxième période (T2) directement après la première période (T1) coïncidant avec le temps de maintien (t_{hold}) du deuxième élément d'échantillonnage et maintien (20, S3),
- le noyau magnétique d'un deuxième transformateur (28) est modulé par une impulsion rectangulaire de la deuxième séquence d'impulsions (P2) appliquée du côté primaire,
- le premier transformateur (26) ne reçoit pas de signal de générateur (U_{sig}) selon la première séquence d'impulsions (P1) décalée dans le temps et est maintenu à 0 V du côté primaire et du côté secondaire durant la réduction de l'énergie accumulée,
- par suite de la modulation côté primaire, la deuxième tension partielle (U2) s'établit du côté secondaire du deuxième transformateur (26).

4. Procédé selon l'une quelconque des revendications 1 à 3, **caractérisé en ce que**
le signal de générateur (U_{sig}) prend une forme d'onde quelconque, y compris une tension continue, et est en particulier une tension de signal rectangulaire.

5. Dispositif de l'application d'une tension de signal de mesure à un réseau d'alimentation électrique, le dispositif comprenant un générateur de signal destiné à fournir un signal de générateur et un dispositif de transmission destiné à transmettre par induction le signal de générateur dans le réseau d'alimentation électrique, **caractérisé en ce que**
le dispositif de transmission comprend un moyen de commutation (20) côté primaire pour l'échantillonnage du signal de générateur (U_{sig}) et à diviser les valeurs échantillonnées en deux séquences d'impulsions (P1, P2) décalées dans le temps l'une à l'autre, deux transformateurs (26, 28) connectés en série du côté sortie pour la transmission séparée par induction des séquences d'impulsions (P1, P2) et un moyen de commutation (40) côté secondaire pour l'addition des séquences d'impulsions induites décalées dans le temps.

6. Dispositif selon la revendication 5,
**caractérisé en ce que**
le moyen de commutation (20) côté primaire se compose de deux éléments de commutation (S1, S3) qui connectent en alternance l'enroulement primaire (22, 24) de chaque transformateur (26, 28) au générateur de signal (U_{sig}) et comprend deux autres éléments de commutation (S2, S4) qui court-circuitent en alternance l'enroulement primaire (22, 24) respectif.

7. Dispositif selon la revendication 5 ou la revendication 6,
**caractérisé en ce que**
le moyen de commutation (40) côté secondaire se compose d'un premier couplage (SG1), qui connecte les tensions induites (U1) du premier transformateur (26) au réseau d'alimentation électrique (4) ou court-circuite ses enroulements secondaires (30, 31, 32), et d'un deuxième couplage (SG2) connecté en série, qui connecte, en alternance à ce dernier, les tensions induites (U2) du deuxième transformateur au réseau d'alimentation électrique (4) ou court-circuite ses enroulements secondaires (34, 35, 36).

8. Dispositif selon la revendication 6 ou la revendication 7,
**caractérisé en ce que**
les éléments de commutation (S1, S2, S3, S4, SG1, SG2) des moyens de commutation (20, 40) sont réalisés comme éléments de commutation semi-conducteurs.

9. Dispositif selon l'une quelconque des revendications 5 à 8,
**caractérisé par**
un circuit de commande pour la commande temporelle des moyens de commutation primaires et secondaires (20, 40).

10. Dispositif selon l'une quelconque des revendications 5 à 9,
**caractérisé en ce que**
chacun des deux transformateurs (26, 28) a une section transversale du noyau inférieure à celle d'un seul transformateur générant la même tension secondaire lors de la transmission par transformateur conventionnelle à basse fréquence.
